# EUROPÄISCHE PATENTSCHRIFT

(11) **EP 0 562 393 B1**
(45) Veröffentlichungstag und Bekanntmachung des Hinweises auf die Patenterteilung: **08.11.1995**
(21) Anmeldenummer: 93104080.2
(22) Anmeldetag: 12.03.1993
(51) Int. Cl.: C23C 18/30

(54) **Verfahren zur Verbesserung der Haftfestigkeit von stromlos abgeschiedenen Metallschichten**
Process for improving the adhesion of electrolessly deposited metal coatings
Procédé pour perfectionner l'adhérence des revêtements métalliques déposés par voie chimique

(30) Priorität: 25.03.1992 DE 4209708
(43) Veröffentlichungstag der Anmeldung: 29.09.1993
(73) Patentinhaber: BAYER AG, 51368 Leverkusen (DE)
(72) Erfinder: Giesecke, Henning, Dr., W-5000 Köln 80 (DE); Wolf, Gerhard-Dieter, Dr., W-4047 Dormagen 5 (DE); Haese, Wilfried, Dr., W-5068 Odenthal (DE)

(56) Entgegenhaltungen:
- EP-A- 0 214 097
- EP-A- 0 256 395
- EP-A- 0 456 908
- GB-A- 2 169 925
- PATENT ABSTRACTS OF JAPAN, unexamined applications, C Field, Band 14, Nr. 497, 30. Oktober 1990 THE PATENT OFFICE JAPANESE GOVERNMENT Seite 26 C 774

## Beschreibung

Die Erfindung betrifft ein Verfahren zur Herstellung besser haftender Metallschichten auf nicht leitenden Substraten, wobei ein UV-härtbarer Lack als Binder für Edelmetallverbindungen (Aktivatoren) eingesetzt wird, der zusätzlich entweder Füllstoffe oder Lösungsmittel oder eine Kombination von Füllstoffen und Lösungsmitteln enthält.

Es ist bekannt, daß man zur Erzielung haftfester Metallauflagen auf elektrisch nicht leitenden Substraten zunächst einen haftvermittelnden Lack auf die Oberfläche dieser Substrate aufträgt. Der Nachteil dieser Vorbehandlungsmethode, bei der beispielsweise ABS-Polymerisate eingesetzt werden, besteht jedoch darin, daß ein mit einer solchen Lackschicht überzogener Formkörper vor der eigentlichen Metallisierung zur Aufrauhung der Oberfläche mit einer Beize behandelt werden muß (DE-OS 19 58 839).

Es ist deshalb bereits vorgeschlagen worden, nichtmetallische Substrate ohne vorheriges Beizen direkt mit einer Aktivatorlösung für die stromlose Metallisierung zu behandeln, die als Haftvermittlung Gemische, beispielsweise aus Acrylnitril/Butadien-Copolymerisaten und gegebenenfalls Phenolharzen enthält; solche Gemische sind recht kompliziert zusammengesetzt (US 3.305.460; US 3.560.257). Die Haftfestigkeit der erzeugten Metallschichten ist dennoch nicht ausreichend, und die haftvermittelnden Polymere erfüllen nicht die hohen Anforderungen, die für die thermischen und elektrischen Eigenschaften beispielsweise von Leiterplatten gefordert werden. Daher konnte sich ein derartiges Verfahren bisher in der Technik nicht durchsetzen.

Das Verfahren gemäß US 4.368.281 liefert demgegenüber zwar bessere Haftfestigkeiten, jedoch werden in diesem Verfahren unverhältnismäßig hohe Aktivatormengen, nämlich 5 bis 16 Gew.-%, bezogen auf die Gesamtmenge an Haftvermittler, benötigt.

Unter Verwendung von geringen Aktivatormengen konnten gute Haftfestigkeiten bisher nur dann erreicht werden, wenn man Substratoberflächen mit Formulierungen behandelt, die als wesentliche Bestandteile Edelmetallverbindungen (Aktivatoren), Bindemittel, Füllstoffe und mehr als 40 Gew.-%, bezogen auf den gesamten Haftvermittler, an Lösungsmitteln enthalten, Solche Verfahren sind in DE-OS 36 27 256, DE-OS 36 25 587 und DE-OS 37 43 780 beschrieben. Die gute Metallhaftung auf diesen Formulierungen wird darauf zurückgeführt, daß beim Trocknen des Haftvermittlers rauhe, poröse Oberflächen entstehen, in die sich die stromlos abgeschiedenen Metallschichten verankern können.

Es wurde nun gefunden, daß man auch auf der Basis von UV-härtbaren Lacken Metallisierungen mit hervorragenden Haftfestigkeiten erzeugen kann, wenn man solchen UV-härtbaren Lacken als wesentliche Bestandteile Edelmetallverbindungen (Aktivatoren) und Füllstoffe oder Edelmetallverbindungen und bis zu 25 Gew.-% an Lösungsmitteln oder Edelmetallverbindungen und eine Kombination von Füllstoffen und bis zu 25 Gew.-% an Lösungsmitteln zumischt. Das erfindungsgemäße Verfahren ist um so überraschender, als bei der bekanntermaßen raschen UV-Härtung glatte und an den Oberflächen geschlossene Lackschichten gebildet werden.

Es wurde ein Verfahren zur stromlosen Abscheidung von festhaftenden Metallschichten auf UV-härtbaren Lacken, im wesentlichen bestehend aus den Verfahrensschritten
a) Beschichten der Oberflächen mit UV-härtbaren Formulierungen,
b) Aushärten der beschichteten Oberflächen mit UV-Strahlung und
c) stromlose Metallisierung der UV-gehärteten Schichten,
gefunden, das dadurch gekennzeichnet ist, daß die Formulierungen der Lacke neben den üblichen Bestandteilen von UV-härtbaren Lacken 0,5 bis 5 Gew.-% an Edelmetallverbindungen der 1. oder 8. Nebengruppe des Periodensystems (Mendelejew) als Metallisierungsaktivatoren und zusätzlich entweder 2 bis 20 Gew.-% an Füllstoffen oder bis zu 25 Gew.-% an Lösungsmitteln oder eine Kombination von 2 bis 20 Gew.-% an Füllstoffen und bis zu 25 Gew.-% an Lösungsmitteln enthalten, wobei alle Gewichtsangaben auf die gesamte Formulierung bezogen sind.

Die erfindungsgemäß einsetzbaren neuen Formulierungen enthalten demnach neben den für UV-Lacken üblichen Bindemitteln, reaktiven Verdünnern und Fotoinitiatoren als wesentliche Bestandteile zum einen die genannten Edelmetallverbindungen und zum anderen entweder Füllstoffe oder Lösungsmittel oder eine Kombination beider.

UV-härtbare Lacke sind dem Fachmann bekannt. Als Beispiele seien genannt: ungesättigte Polyester, Polyesteracrylate, Epoxyacrylate und Urethanacrylate. Reaktive Verdünner für UV-Lacke sind ebenfalls bekannt; beispielsweise seien genannt: Styrol, Vinylacetat, N-Vinylpyrrolidon, 2-Ethylhexylacrylat, 2-Ethoxyethylacrylat als monofunktionelle Verbindungen und 1,6-Hexandioldiacrylat, Trimethylolpropan-acrylate, Tripropylenglykol-diacrylat, Trimethylolpropyl-formalmonoacrylat, Pentaerythritol-tetraacrylat als vernetzende mehrfunktionelle Verbindungen. Auch hierfür einsetzbare Fotoinitiatoren sind dem Fachmann bekannt und sind beispielsweise: Diketale, Benzoinether, Acetophenone, Benzophenone und Thioxanthone. Systeme, die UV-härtbare Bindemittel, reaktive Verdünner und Fotoinitiatoren der genannten Art enthalten, sind beispielsweise beschrieben in US 3.968.305, EP 274 593, EP 274 596, EP 20 344, US 3.297.745, US 3.673.140.

Wesentlich für die erfindungsgemäß eingesetzte Formulierung des Haftvermittler Lacks ist ein Gehalt an 0,5 bis 5 Gew.-%, bevorzugt 0,8 bis 4 Gew.-%, besonders bevorzugt 1 bis 3 Gew.-% an Edelmetallverbindungen der 1. oder 8. Nebengruppe des Periodensystems (Mendelejew). Die Angaben in Gew.-% sind auf die Gesamtmenge des Haftvermittlers bezogen. Die Edelmetallverbindungen liegen in den erfindungsgemäß einzusetzenden Formulierungen entweder gelöst oder in fein dispergierter Form mit Teilchengrößen unterhalb von 5 µm vor. Von allen in der 1. und 8. Nebengruppe des Periodensystems enthaltenen Edelmetallen werden Platin, Palladium, Gold und Silber bevorzugt eingesetzt. Die Edelmetalle können in Form einer anorganischen oder organischen Verbindung, bevorzugt in Form einer organischen Verbindung, eingesetzt werden. Solche organischen Verbindungen sind vielfach Komplexe. Sie können hergestellt werden unter Einsatz von Olefinen (Dienen), von α,β-ungesättigten Carbonylverbindungen, von Kronenethern, von Nitrilen und von Diketonen, wie Pentadion-2,4. Einige wichtige Beispiele solcher organischer Edelmetallverbindungen sind: 1,2- und 1,3-Butadien-palladiumdichlorid, Bisacetonitrilpalladiumdichlorid, Bisbenzonitril-palladiumdichlorid, 4-Cyclohexen-1,2-dicarbonsäureanhydrid-palladiumdichlorid, Mesityloxid-palladiumchlorid, 3-Hepten-2-on-palladiumchlorid, 5-Methyl-3-hexen-2-on-palladiumchlorid und Bispentadion-2,4-palladium. Diese Beispiele zeigen die besondere Bevorzugung von Palladiumverbindungen.

Der Einsatz von Edelmetallverbindungen der 1. oder 8. Nebengruppe des Periodensystems der genannten Art ohne zusätzliches Bindemittel ist aus DE-OS 30 25 307 und DE-OS 31 48 280 sowie DE-OS 33 24 767 bekannt.

Wenngleich es erfindungsgemäß möglich ist, ein Gemisch mehrerer Edelmetallverbindungen einzusetzen, ist es aus Gründen der einfacheren Herstellweise bevorzugt, nur eine Edelmetallverbindung zu verwenden.

Ein weiterer wesentlicher Bestandteil der erfindungsgemäß einzusetzenden Bindemittel(Lack-)Formulierungen ist der Gehalt entweder an Füllstoffen oder an Lösungsmitteln bis zu 25 Gew.-% oder an einer Kombination aus Füllstoffen oder einer solchen Menge an Lösungsmittel. Fehlen solche erfindungsgemäßen Anteile in den Formulierungen, so erhält man lediglich ausreichend festhaftende Lackierungen auf den damit beschichteten Substraten, die beispielsweise den Gitterschnittest mit Ergebnissen GT 1 bis GT 0 erreichen (DIN 53 151). Werden auf solchen Lacken jedoch Metallschichten stromlos abgeschieden, reicht die Haftung dieser Metallschichten für viele technische Einsatzzwecke, beispielsweise für Leiterplatten, nicht aus, wenn man Füllstoffe oder Lösungsmittel oder eine Kombination beider fortläßt.

Eine der erfindungsgemäßen Maßnahmen ist daher die Kombination der genannten Edelmetallverbindungen mit 2 bis 20 Gew.-%, bevorzugt 3 bis 15 Gew.-%, ganz besonders bevorzugt 5 bis 15 Gew.-%, bezogen auf die Gesamtmenge der Formulierung.

Die Füllstoffe werden den erfindungsgemäß einzusetzenden Formulierungen in fein verteilter Form mit einer Teilchengröße von unterhalb 5 µm zugesetzt. Selbstverständlich können auch Gemische verschiedener Füllstoffe verwendet werden. Als Füllstoffe kommen die auch ansonsten aus der Druck- bzw. Lackierungstechnik bekannten Hilfsstoffe, wie Pigmente, disperse Kieselsäuren, Tonmineralien, Ruße und rheologische Additive in Betracht. Beispiele hierfür sind: Aerosile, TiO₂, Talkum, Eisenoxide, Kieselgur, Schwerspate, Kaoline, Quarzmehl, Smectite, Farbruße, Graphite, Zinksulfide, Chromgelb, Bronzen, organische Pigmente und Kreide. Solche Pigmente müssen ferner die Forderung erfüllen, die anschließende UV-Härtung der Formulierung nicht oder nicht wesentlich zu beeinträchtigen.

Füllstoffe wurden auch bereits in den Formulierungen der genannten DE-OS 36 27 256, DE-OS 36 25 587 und DE-OS 37 43 780 eingesetzt; während dort jedoch in den physikalisch trocknenden und viel Lösungsmittel enthaltenden Formulierungen große Mengen an Füllstoffen eingesetzt werden müssen, ist es bei den erfindungsgemäß angewandten UV-härtenden Systemen möglich, bedeutend geringere Anteile an Füllstoffen, bezogen auf das Bindemittel, einzusetzen und dennoch hervorragende Haftungen zu erzielen.

Eine weitere Variante in den erfindungsgemäß einsetzbaren UV-härtbaren Formulierungen besteht darin, zusätzlich zu den genannten Edelmetallverbindungen Lösungsmittel in einer Menge bis zu 25 Gew.-%, beispielsweise 1 bis 25 Gew.-%, bevorzugt 5 bis 20 Gew.-%, ganz besonders bevorzugt 10 bis 20 Gew.-%, an Lösungsmitteln zuzusetzen, wobei die Gewichtsanteile auf das Gesamtgewicht der Formulierung bezogen sind. Bei dieser Variante ist es von Vorteil, daß die lösungsmittelhaltigen Formulierungen ohne vorheriges Trocknen der UV-Härtung unterworfen werden können.

Lösungsmittel, die für diese Variante in Frage kommen, sind in der Druck- bzw. Lackiertechnik bekannt. Beispiele sind: aromatische und aliphatische Kohlenwasserstoffe, wie Toluol, Xylol, Trimethylbenzole, Petrolether und andere; alkoholische Verbindungen, wie Glycerin, Ethylenglykole, Propylenglykole; Ketone, wie Methylbutylketon, Cyclohexanon, Methylisobutylketon; Ester, wie Essigsäurebutylester, Phthalsäuredioctylester, Glykolsäurebutylester; Glykolether, wie Ethylenglykolmonomethylether, Diethylenglykolmethylether, Diglyme, Propylenglykolmonomethylether; Ester von Glykolethern, wie Ethylglykolacetat, Propylenglykolmonomethyletheracetat; Halogenkohlenwasserstoffe; Diacetonalkohol. Selbstverständlich können auch Gemische mehrerer dieser Lösungsmittel und ihre Verschnitte mit anderen Lösungsmitteln eingesetzt werden.

Nicht aus technischen oder funktionalen Gründen, sondern aus Gründen der Arbeitsplatzsicherheit ist es zweckmäßig, Lösungsmittelgemische mit einem Flammpunkt von mehr als 21°C einzusetzen.

Eine noch weitere Ausführungsvariante der erfindungsgemäß einzusetzenden UV-härtbaren Formulierungen ist der Zusatz von Edelmetallverbindungen und einer Kombination der genannten Füllstoffe und Lösungsmittel. Auch in solchen Kombinationen können die Füllstoffe und die Lösungsmittel in den oben bezeichneten Mengen zum Einsatz kommen.

Weitere Zusätze zu den erfindungsgemäß einsetzbaren Formulierungen sind solche, die ihre funktionellen Eigenschaften nicht beeinträchtigen, beispielsweise Verlaufsmittel, wie Silicone, Tenside und andere oder Farbstoffe, beispielsweise zur Kennzeichnung und Unterscheidung.

Die Herstellung der erfindungsgemäß einsetzbaren Formulierungen geschieht im allgemeinen durch Vermischen der Bestandteile. Hierzu sind neben dem einfachen Rühren besonders die in der Lack- und Drucktechnik üblichen Naß-zerkleinerungsaggregate, wie Kneter, Attritore, Walzenstühle, Rührer mit Dispergierscheiben, Rotor-Stator-Mühlen, Kugelmühlen sowie Rührwerksmühlen besonders geeignet. Selbstverständlich kann das Einarbeiten der Formulierungsbestandteile auch in getrennten Schritten durchgeführt werden.

Beispielsweise kann man den Aktivator (Edelmetallverbindung) zuerst in den Bindemitteln, reaktiven Verdünnern und gegebenenfalls Lösungsmitteln lösen bzw. dispergieren und dann erst Füllstoffe einarbeiten. Auch ein vorheriges Anteigen der Füllstoffe in den Lösungsmitteln und reaktiven Verdünnern unter hohen Scherkräften ist eine geeignete Verfahrensvariante.

Eine noch weitere Verfahrensvariante besteht darin, daß man Edelmetallverbindungen, Füllstoffe und gegebenenfalls Lösungsmittel direkt in fertig formulierte UV-härtbare Lacksysteme einarbeitet. Dieses Verfahren bietet sich besonders bei Verwendung von löslichen organischen Edelmetallverbindungen und von Füllstoffen, wie Aerosilen, modifiziertem TiO₂, Bentoniten und anderen an.

Durch das Aufbringen der beschriebenen Formulierungen können Oberflächen nicht leitender Substrate für eine stromlose Metallisierung aktiviert werden, wobei außerordentlich haftfeste Metallschichten entstehen. Das Aufbringen erfolgt im allgemeinen mit Hilfe der aus der Lack-, Druck- bzw. Leiterplattentechnik bekannten Verfahren. Dabei können die Oberflächen vollständig oder auch nur teilweise beschichtet werden. Eine teilweise Beschichtung wird beispielsweise bei der additiven Herstellung von Leiterplatten bzw. bei der Erzeugung von partiellen Abschirmflächen angewandt. Solche Verfahren zum Aufbringen sind beispielsweise: Aufsprühen, Aufpinseln, Aufrollen, Offsetdruck, Siebdruck, Tampondruck, Tauchen, "Vorhang"-Beschichtungen. Zur Herstellung dickerer Schichten ist es auch möglich, den Beschichtungsvorgang zu wiederholen. Selbstverständlich kann man mit Hilfe der erfindungsgemäß zu verwendenden Formulierungen auch nach bekannten Verfahren Trockenfilme herstellen und damit die Substratoberflächen beschichten. Die Dicke der Beschichtungen sollte 0,5 bis 50 µm, bevorzugt 1 bis 30 µm betragen.

Nach dem Beschichten können die aufgetragenen Formulierungen getrocknet werden. Im allgemeinen empfiehlt sich ein derartiger Trockenschritt nur dann, wenn anschließend durch eine partielle Belichtung auf den Oberflächen Strukturen erzeugt werden sollen. Für den Fall einer solchen Trocknung kann dies beispielsweise bei einer Temperatur im Bereich von Raumtemperatur bis 150°C und unter Normaldruck oder vermindertem Druck erfolgen. Die Trocknungszeiten können hierbei selbstverständlich stark variiert werden. Häufig genügen sehr kurze Zeiten (10-20 Minuten).

Die chemische Härtung der Lackauflagen wird mittels UV-Strahlung der Wellenlänge 360 bis 180 nm im Verlaufe von 1 Sekunde bis zu mehreren Minuten durchgeführt. Selbstverständlich kann anstelle von UV-Strahlung oder UV-Strahlung enthaltendem Licht auch mit anderen aktiven Strahlen, wie mit Röntgenstrahlen, gehärtet und vernetzt werden. In einem solchen Falle könnte man sogar auf die Zugabe von Fotoinitiatoren zu den Formulierungen verzichten.

Die in der Leiterplattentechnik häufig angewandte Variante, daß man die Oberflächen von Substraten zwar vollständig beschichtet, die beschichteten Flächen jedoch nur partiell belichtet und die an den nicht belichteten Platten auch nicht gehärteten Lackauflagen anschließend wieder entfernt, kann selbstverständlich auch mit den erfindungsgemäß einsetzbaren Formulierungen ausgeführt werden.

Als nicht-leitende Substrate für eine erfindungsgemäße Beschichtung eignen sich beispielsweise: Glas, Quarz, Keramik, Emaille, Papier, Polyethylen, Polypropylen, Epoxidharze, Polyester, Polycarbonate, Polyamide, Polyimide, Polyhydantoine, ABS-Kunststoffe, Silicone, Polyvinylhalogenide, Polyphenylensulfide, Polytetrafluorethylene. Diese Substrate können in Form von Platten, Folien, Papieren und Vliesen eingesetzt werden. Besondere Bedeutung haben Substrate, wie sie in der Leiterplattenfertigung eingesetzt werden, beispielsweise Phenolharzpapier, Glasfaser-verstärkte Epoxidplatten, Polyester-, Polyimidfolien und Keramik.

Die mit den erfindungsgemäß einsetzbaren Formulierungen beschichteten Oberflachen müssen anschließend durch Reduktion für nachfolgende stromlose Metallabscheidung aktiviert werden. Dazu können bevorzugt die in der Galvanotechnik üblichen Reduktionsmittel, wie Formaldehyd, Hypophosphit, Borane, Hydrazinhydrat verwendet werden. Selbstverständlich sind grundsätzlich auch andere, dem Fachmann geläufige Reduktionsmittel möglich.

Eine besonders bevorzugte Ausführungsform dieser Reduktion besteht darin, daß sie im Metallisierungsbad mit dem in solchen Bädern vorhandenen Reduktionsmittel durchgeführt wird. Diese Ausführung ist besonders für aminboranhaltige Nickelbäder oder formalinhaltige Kupferbäder geeignet.

Die für die stromlose Metallisierung in Frage kommenden Bäder sind dem Fachmann grundsätzlich bekannt. Es handelt sich hierbei um Bäder mit Salzen der Metalle Kobalt, Eisen, Kupfer, Silber, Gold, Palladium und anderen sowie deren Gemische.

Das erfindungsgemäße Verfahren eignet sich besonders für die Abscheidung von Metallschichten für gedruckte Schaltungen, Folientastaturen, Schaltmatten, Sensoren und Abschirmflächen.

### Beispiele

### Beispiel 1

A. 60 Gew.-Teile eines aliphatischen Urethanacrylats (Viskosität bei 23°C ca. 59 000 mPa.s), 27 Gew.-Teile Triacrylat des propoxylierten Trimethylolpropans (Viskosität bei 23°C ca. 150 mPa.s) wurden mit 5 Gew.-Teilen Benzildimethylketal mittels eines Dissolvers vermischt.
B. In die Lösung A wurden nacheinander mittels eines Ultra-Turrax-Mischers 3 Gew.-Teile Butadienpalladiumdichlorid, 20 Gew.-Teile ®Shellsol A, 10 Gew.-Teile Glykolsäurebutylester, 7 Gew.-Teile SiO₂ ®Aerosil 380 und 3 Gew.-Teile Talkum eingearbeitet. Man erhielt eine siebdruckfähige Paste (Viskosität bei 23°C ca. 20 000 mPa.s).

Die Paste wurde im Siebdruck auf eine PET-Folie gedruckt. Anschließend wurde der Druck 20 sec. mit UV-Strahlung ausgehärtet und dann in einem stromlosen Kupferbad (1,5 g/l Kupfer, 10 g/l Formalinlösung (30 %ig), 4,5 g/l Natronlauge) bei 60°C verkupfert. Man erhielt eine verkupferte PET-Folie mit einer Metallauflage von ca. 3 µm. Haftfestigkeit gemäß DIN 53 151 (Gitterschnittest) GT O. Haftfestigkeit gemäß DIN 53 494 (Schältest) >25 N/25 mm. (Die Auflage ließ sich nicht ohne Zerstörung der PET-Folie abschälen).

### Beispiel 2

In 100 Gew.-Teile einer UV-härtbaren Lösung gemäß Beispiel 1A wurden 15 Gew.-Teile Butylglykol, 10 Gew.-Teile ®Shellsol A und 2 Gew.-Teile Bisacetonitril-palladiumdichlorid mittels eines Rührers mit Dispergierscheiben eingearbeitet. Mittels eines "Roll-Coater" (Rollbeschichter) wurde mit dieser Formulierung (Viskosität bei 23°C ca. 7000 mPa.s) auf einer PET-Folie ein ca. 25 µm dicker Film erzeugt und gemäß Beispiel 1 UV-gehärtet und metallisiert. Nach Tempern bei 150°C erhielt man eine verkupferte PET-Folie mit einer Haftfestigkeit gemäß DIN 53 494 von 20 N/25 mm.

### Beispiel 3 (Vergleichsbeispiel)

Zu 100 Gew.-Teilen einer UV-härtbaren Mischung gemäß Beispiel 1A wurden 2 Gew.-Teile Butadien-palladiumdichlorid, 25 Gew.-Teile ®Shellsol A und 15 Gew.-Teile Butylglykol mittels eines Rührers mit Dispergierscheiben eingerührt. Mit dieser Lösung wurde gemäß Beispiel 2 eine PET-Folie metallisiert. Man erhielt eine verkupferte PET-Folie mit einer Metallhaftung gemäß DIN 53 151 GT O, gemäß DIN 53 494 ca. 1 N/25 mm.

### Beispiel 4

60 Gew.-Teile eines aliphatischen Urethanacrylats (Viskosität bei 23°C ca. 4000 mPa.s), 40 Gew.-Teile Hexandioldiacrylat und 5 Gew.-Teile Benzildimethylketal wurden mittels eines Rührers mit Dispergierscheiben vermischt. In dieser Lösung wurden 5 Gew.-Teile Bisbenzonitril-palladiumdichlorid, 15 Gew.-Teile Titandioxid und 5 Gew.-Teile ®Aerosil 200 dispergiert. Die fertige Formulierung wurde auf eine Polycarbonatplatte aufgestrichen, UV-gehärtet und gemäß Beispiel 1 verkupfert. Nach Tempern bei 125°C erhielt man eine verkupferte PC-Platte mit einer Haftfestigkeit von 22 N/25 mm.

### Beispiel 5

In 112 Gew.-Teile eines handelsüblichen, alkalisch entwickelbaren, UV-härtbaren Lötstopplacks (DPR-305, Fa. Asahi Chemicals) wurden 3 Gew.-Teile Bisacetonitrilpalladiumdichlorid in 20 Gew.-Teilen N-Methylcaprolactam, 20 Gew.-Teile Methoxypropylacetat und 30 Gew.-Teile Bariumsulfat (Blanc Fixe micro) eingerührt. Die Formulierung wurde mittels Siebdruck flächig auf eine Polyimidfolie (®Kapton) aufgebracht und 30 Min. bei 80°C vorgetrocknet. Anschließend wurde sie 8 Sek. mit einer UV-Lampe durch eine Negativmaske eines Leiterbahnbildes belichtet. Die nicht belichteten Stellen wurden mit 1 %iger Natronlauge ausgewaschen. Anschließend wurde die Folie 30 Min. bei 150°C nachgehärtet und 1 Std. in einem formalinhaltigen Kupferbad (Cu 2g/l, NaOH 3 g/l, Formaldehyd 2 g/l, Temperatur 70°C) verkupfert. Man erhielt eine verkupferte PI-Folie mit Metallhaftungen gemäß DIN 53 151 GT O (MIL P 55 11 00 PA 4,8-4,2 bestanden).

## Patentansprüche

1. Verfahren zur stromlosen Abscheidung von festhaftenden Metallschichten auf UV-härtbaren Lacken, im wesentlichen bestehend aus den Verfahrensschritten
a) Beschichten der Oberflächen mit UV-härtbaren Formulierungen,
b) Aushärten der beschichteten Oberflächen mit UV-Strahlung und
c) stromlose Metallisierung der UV-gehärteten Schichten,
dadurch gekennzeichnet, daß die Formulierungen der Lacke neben den üblichen Bestandteilen von UV-härtbaren Lacken 0,5 bis 5 Gew.-% an Edelmetallverbindungen der 1. oder 8. Nebengruppe des Periodensystems (Mendelejew) als Metallisierungsaktivatoren und zusätzlich entweder 2 bis 20 Gew.-% an Füllstoffen oder bis zu 25 Gew.-% an Lösungsmitteln oder eine Kombination von 2 bis 20 Gew.-% an Füllstoffen und bis zu 25 Gew.-% an Lösungsmitteln enthalten, wobei die Gewichtsangaben auf die Gesamtmenge der Formulierung bezogen sind.

2. Verfahren nach Anspruch 1, dadurch gekennzeichnet, daß man als Edelmetallverbindungen organische Verbindungen der Edelmetalle einsetzt.

3. Verfahren nach Anspruch 1, dadurch gekennzeichnet, daß man als Edelmetallverbindungen organische Verbindungen des Palladiums einsetzt.

4. Verfahren nach Anspruch 1, dadurch gekennzeichnet, daß die Anteile an Edelmetallverbindungen 0,8 bis 4 Gew.-%, bevorzugt 1 bis 3 Gew.-% betragen.

5. Verfahren nach Anspruch 1, dadurch gekennzeichnet, daß die Mengen an Füllstoffen 3 bis 15 Gew.-%, bevorzugt 5 bis 15 Gew.-% betragen.

6. Verfahren nach Anspruch 1, dadurch gekennzeichnet, daß die Lösungsmittelmengen 5 bis 20 Gew.-%, bevorzugt 10 bis 20 Gew.-% betragen.

7. Verfahren nach Anspruch 1, dadurch gekennzeichnet, daß Metallschichten für gedruckte Schaltungen, Folientastaturen, Schaltmatten, Sensoren und Abschirmflächen abgeschieden werden.

## Claims

1. Process for the electroless deposition of strongly adhering metal layers atop UV-curable varnishes, which consists essentially of the steps of
a) coating the surfaces with UV-curable formulations,
b) curing the coated surfaces with UV radiation and
c) electroless metallisation of the UV-cured layers,
characterised in that the formulations of the varnishes contain, as well as the customary components of UV-curable varnishes, 0.5 to 5% by weight of noble metal compounds of subgroup I or VIII of the periodic table (Mendeleev) as metallisation activators and, in addition, either 2 to 20% by weight of fillers or up to 25% by weight of solvents or a combination of 2 to 20% by weight of fillers and up to 25% by weight of solvents, the weights given being based on the entire amount of the formulation.

2. Process according to Claim 1, characterised in that the noble metal compounds used are organic noble metal compounds.

3. Process according to Claim 1, characterised in that the noble metal compounds used are organic palladium compounds.

4. Process according to Claim 1, characterised in that the amounts of noble metal compounds are 0.8 to 4% by weight, preferably 1 to 3% by weight.

5. Process according to Claim 1, characterised in that the amounts of fillers are 3 to 15% by weight, preferably 5 to 15% by weight.

6. Process according to Claim 1, characterised in that the amounts of solvents are 5 to 20% by weight, preferably 10 to 20% by weight.

7. Process according to Claim 1, characterised in that metal layers are deposited for printed circuits, membrane keyboards, switch mats, sensors and electromagnetic screens.

## Revendications

1. Procédé pour la déposition, sans apport de courant, de couches métalliques manifestant une adhérence sur des laques, des vernis ou des peintures durcissables au rayonnement ultraviolet, constitué essentiellement par les étapes opératoires consistant à
a) enduire les surfaces avec des formulations durcissables au rayonnement ultraviolet,
b) durcir à l'aide d'un rayonnement ultraviolet les surfaces enduites, et
c) procéder à la métallisation des couches durcies à l'aide d'un rayonnement ultraviolet, sans apport de courant,
caractérisé en ce que les formulations de laques, de vernis ou de peintures contiennent, outre les constituants habituels de laques, de vernis ou de peintures durcissables au rayonnement ultraviolet, de 0,5 à 5% en poids de composés de métaux nobles du ler ou du 8ème sous-groupe du système périodique (de Mendeleïev) à titre d'activateurs de métallisation et, en outre, soit de 2 à 20% en poids de matières de remplissage, soit jusqu'à concurrence de 25% en poids de solvants ou encore une combinaison de 2 à 20% en poids de matières de remplissage et jusqu'à concurrence de 25% en poids de solvants, les indications pondérales se rapportant à la quantité totale de la formulation.

2. Procédé selon la revendication 1, caractérisé en ce qu'on met en oeuvre, à titre de composés de métaux nobles, des composés organiques des métaux nobles.

3. Procédé selon la revendication 1, caractérisé en ce que, à titre de composés de métaux nobles, on met en oeuvre des composés organiques du palladium.

4. Procédé selon la revendication 1, caractérisé en ce que les fractions de composés de métaux nobles s'élèvent de 0,8 à 4% en poids, de préférence de 1 à 3% en poids.

5. Procédé selon la revendication 1, caractérisé en ce que les quantités de matières de remplissage s'élèvent de 3 à 15% en poids, de préférence de 5 à 15% en poids.

6. Procédé selon la revendication 1, caractérisé en ce que les quantités de solvants s'élèvent de 5 à 20% en poids, de préférence de 10 à 20% en poids.

7. Procédé selon la revendication 1, caractérisé en ce qu'on procède à la déposition des couches métalliques pour des circuits imprimés, des claviers à effleurement, des mats de commutation, des détecteurs et des surfaces de blindage.
